Europäisches Patentamt

European Patent Office

Office européen des brevets

(11) Publication number: **0 392 226**

A1

## EUROPEAN PATENT APPLICATION

(21) Application number: 90105338.9

(22) Date of filing: **21.03.90**

(51) Int. Cl.5: **B32B 31/04, B32B 31/20, B29C 43/56**

(30) Priority: 23.03.89 JP 69239/89
23.03.89 JP 69240/89
23.03.89 JP 69241/89
23.03.89 JP 69242/89

(43) Date of publication of application:
**17.10.90 Bulletin  90/42**

(84) Designated Contracting States:
**DE FR GB**

(71) Applicant: **MITSUBISHI GAS CHEMICAL COMPANY, INC.**
**No. 5-2, Marunouchi-cho, 2-chome**
**Chiyoda-ku**
**Tokyo(JP)**

(72) Inventor: **Gaku, Morio, c/o Mitsubishi Gas Chemical**
**Company, Inc, 5-2, Marunouchi 2-chome**
**Chiyoda-ku, Tokyo(JP)**
Inventor: **Noguchi, Kazuo, c/o Mitsubishi Gas Chemical**
**Company, Inc, 1-1, Niijuku 6-chome**
**Katsushika-ku, Tokyo(JP)**
Inventor: **Nemoto, Shigeo, c/o Mitsubishi Gas Chemical**
**Company, Inc, 1-1, Niijuku 6-chome**
**Katsushika-ku, Tokyo(JP)**

(74) Representative: **Füchsle, Klaus, Dipl.-Ing. et al**
**Hoffmann . Eitle & Partner Patentanwälte**
**Arabellastrasse 4**
**D-8000 München 81(DE)**

(54) **Vacuum, continuous batch process for producing laminates and apparatus for such process.**

(57) The invention relates to a vacuum, continuous batch process for producing laminates, which comprises repeating a cycle comprsing placing a pre-assembled set of laminate materials containing a prepreg in a vacuum (A) of 100 Torr or less at a temperature not higher than the melting point of the prepreg-impregnating resin, transferring the set of laminate materials under the reduced pressure to the space between hot platens of a pressing machine (B), pressing the set of laminate materials until said prepreg-impregnating resin is cured to a desired degree, opening the hot platens, and then withdrawing (C) a laminate formed by the pressing, and an apparatus for use in such a process. The process is suitable for the production lines for producing laminates, particularly multilayer board, and provides laminate having excellent properties.

FIG 1

# VACUUM, CONTINUOUS BATCH PROCESS FOR PRODUCING LAMINATES AND APPARATUS FOR SUCH PROCESS

## FIELD OF THE INVENTION

The present invention relates to a novel process for batch-wise and continuously producing laminates in which one laminate, such as copper-clad laminate or multilayer board, is formed in a short period of time basically by one pressing operation that is conducted under reduced pressure, and an apparatus for use in such process. The process of this invention is suitable for the production lines for producing laminates, especially multilayer boards, and is excellent in the properties of laminates produced and in suitability to such production lines.

## BACKGROUND OF THE INVENTION

Conventional processes for producing a multilayer board comprise normally purchasing copper-clad laminates, prepregs for the bonding between laminate materials, copper foils, etc., forming on the copper-clad laminates a printed wiring for inner layers to prepare inner-layer plates, assembling the laminate materials into a construction of, for example, copper foil/prepreg/inner-layer plate/prepreg......./inner-layer plate/prepreg/copper foil, pressing this assembly to form a laminate, and then suitably subjecting this laminate to additional steps to form through-holes, an outer-layer wiring, etc., thereby obtaining a multilayer board product. Although some of the thus-manufactured products are as large as 800 mm square, these products are generally 500 mm square or smaller, and vacuum pressing is most suitable for the pressing to produce such multilayer boards.

Copper-clad laminates, on the other hand, are produced by laminate manufacturers using huge multi-opening presses etc., and the products thus produced include standard-size copper-clad laminates 1,000 mm square and also ones measuring 1,000 mm x 2,000 mm from the standpoints of heightening the yield and diminishing waste edge portions. With a view to improving productivity, production by continuous pressing is being intensively studied, but general-purpose laminates having good properties have not yet been produced by continuous pressing.

The present inventors conducted intensive studies to apply continuous pressing to practical production. As a result, it was found that continuous pressing was suitable not for the production of cured copper-clad laminates but for the production of semicured copper-clad laminates. However, it was substantially impossible for continuous pressing to produce multilayer boards using inner-layer plates obtained by conventional processes for producing printed wiring boards.

Under these circumstances, the present inventors have now found that a laminate-producing process more suitable for conventional processes for producing printed wiring boards can be obtained by combining the production of semicured-resin copper-clad laminates and vacuum pressing for producing void-free products with a novel idea that one laminate is produced basically by one pressing operation. The present invention has been completed based on the above.

Accordingly, one object of the present invention is to provide a vacuum, continuous batch process for producing laminates, which gives laminate products with good properties and shows excellent suitability to the existing production lines for laminates.

Another object of the present invention is to provide an apparatus for use in the above process.

## BRIEF DESCRIPTION OF THE DRAWINGS

Figure 1 illustrates the basic construction of an example of the pressing apparatus of this invention for vacuum, continuous batch pressing;

Figure 2 illustrates the basic construction of an example of the pressing apparatus of this invention in which a continuous metal foil is used as a transferring means;

Figures 3 and 4 each illustrates the basic construction of an example of the pressing apparatus of this invention in which an endless metal foil belt is used as a transferring means;

Figures 5 and 6 each illustrates the basic construction of an example of the pressing apparatus of this invention which is made up of units; and

Figures 7, 8, and 9 each illustrates exemplary arrangement of the units of the pressing apparatus of this invention.

## DETAILED DESCRIPTION OF THE INVENTION

## SUMMARY OF THE INVENTION

One embodiment of the present invention is a vacuum, continuous batch process for producing laminates, which comprises repeating a cycle comprising placing a pre-assembled set of laminate materials containing a prepreg in a vacuum of 100 Torr or less at a temperature not higher than the melting point of the prepreg-impregnating resin, transferring the set of laminate materials under the reduced pressure to the space between hot platens of a pressing machine, pressing the set of laminate materials until the prepreg-impregnating resin is cured to a desired degree, opening the hot platens, and then withdrawing a laminate formed by the pressing.

In preferred embodiments of the above process, the set of laminate materials is for a copper-clad laminate or for a multilayer board; the pressing is conducted in such a manner that the prepreg resin in the laminate obtained is in a semicured state; the transfer of the set of laminate materials under reduced pressure is conducted by means of a continuous metal foil; and the transfer of the set of laminate materials under reduced pressure is conducted by means of an endless metal foil belt.

Another embodiment of this invention is a pressing apparatus for vacuum, continuous batch pressing which comprises a prevacuum chamber (A) for keeping a set of laminate materials under reduced pressure, a pressing machine (B), a withdrawal chamber (C) which can be kept vacuum, a transferring means (D) for transferring a set of laminate materials and a laminate, and a vacuumizing system for evacuating the A, B, and C, the A, B, and C being connected in series in this order.

In preferred embodiments of the above apparatus, the pressing machine B is composed of at least two pressing machines arranged in series; the prevacuum chamber A is provided with a vacuumizeable laminate material set table (A1) and the withdrawal chamber C is provided with a vacuumizeable laninate table (C1); the transferring means D is a continuous metal foil; the prevacuum chamber A is provided with a continuous metal foil feed roll unit (M1) in which the continuous metal foil has been wound around the roll, and the withdrawal chamber C is provided with a wind-up roll unit (M2) for the continuous metal foil, part of the continuous metal foil being stretched at least along the floor of the inside of the apparatus from the prevacuum chamber A to the withdrawal chamber C, the stretched part of the continuous metal foil being able to be run freely; the continuous metal foil is a foil made of a metal selected from aluminum, stainless steel, and steel and having a surface roughness of 1 $\mu$m or less, and functions as a mirror plate; after being used, a roll of the continuous metal foil is cleaned in a separate process and reused; the transferring means D is an endless metal foil belt; the prevacuum chamber A and the withdrawal chamber C each is provided with a housing and driving unit for an endless mirror foil belt (M1, M2), and the endless metal foil belt is stretched at least along the floor of the inside of the apparatus from the prevacuum chamber A to the withdrawal chamber C, the endless metal foil belt being able to be run freely; the whole of the endless metal foil belt is housed in the vacuumizeable inside of the apparatus; and the endless metal foil belt is a foil made of a metal selected from stainless steel and steel and having a surface roughness of 1 $\mu$m or less, and one or both ends are suitably provided with a means for cleaning the belt and applying a release agent to the belt.

Still another embodiment of this invention is a pressing apparatus for vacuum, continuous batch pressing which comprises a prevacuum chamber (A) for keeping at least a set of laminate materials under reduced pressure, a pressing machine (B), a withdrawal chamber (C) which can be kept vacuum, a transferring means (D) for transferring a set of laminate materials and a laminate, and a vacuumizing system for evacuating the A, B, and C, the A, B, and C being connected in series in this order, each of the A, B, and C being a unit which can be airtightly connected with other unit or units and separated therefrom, the transferring means being disposed in each unit independently.

In preferred embodiments of the above apparatus, the transferring means D is a chuck-type transferring means; the transferring means in the prevacuum chamber A or the withdrawal chamber C is a roller conveyor or a belt roller conveyor; and the transferring means in the pressing machine B is a continuous metal foil or an endless metal foil belt, and the pressing machine is able to be provided with a removable housing and driving unit for the continuous metal foil or endless metal foil belt.

The present invention will be explained below with respect to its constitution.

The laminate materials constituting the set of laminate materials used in the process of this invention are not particularly limited, and any of the laminate material used for conventional copper-clad laminates and multilayer boards and materials newly developed for these applications can be employed. Examples of the laminate materials for such conventional laminates include a copper foil, a prepreg (hereinafter referred to as "PP"), a single-side copper-clad laminate (hereinafter referred to as "single-sided board"), a printed wiring board with its one side having a printed wiring and the other side having no wiring (hereinafter referred to as "single-sided PWB"), and a printed wiring board for use as an inner layer (hereinafter referred to as "PWB"). In view of the vacuum, continuous batch pressing in the process of this invention, preferred as PP are ones which show little or no resin flow from the edges thereof at the time of pressing. In general, a PP which shows a resin flow from the periphery thereof of 10 mm or less is particularly preferred. Dust-free PPs are also particularly preferably used since PPs that release resin powders or glass powders from the edges thereof will often result in poor products. Examples of such dust-free PPs include one obtained by heating a PP under reduced pressure to a temperature around the melting point of the PP resin to perform predrying, and then passing the resulting PP through rolls, etc. In the case where a PP which shows a considerable resin flow or a PP in which certain parts thereof show considerable resin flows depending on the kind of the pattern of the inner-layer printed wiring is used, it is preferred that the resin flowing from the PP be prevented from flowing onto the inside of the pressing machine or onto the mirror plate by using a copper foil having a large marginal area, corrugating the marginal area of a copper foil, applying a paper tape or the like to the marginal area of a copper foil, or taking other proper measure, in preparing the set of laminate materials as described below, or it is preferred that a release agent be applied beforehand on the mirror plate or a metal foil or the like which functions as a mirror plate, in order that the resin that has flowed out onto the mirror plate, etc., can be easily wiped off.

Examples of the pre-assembled set of laminate materials according to the present invention include: an assembly of laminate materials for a combined single-side copper-clad laminate, which assembly comprising copper foil/at least one PP (hereinafter referred to as "MPP")/releasable film/MPP/copper foil; an assembly of laminate materials for a double-side copper-clad laminate, which assembly comprises, for example, copper foil/MPP/copper foil, or copper foil/MPP/metal plate for the core/MPP/copper foil; and an assembly of laminate materials for a multilayer printed wiring board, which assembly comrises, for example, copper foil/MPP/PWB/MPP/....../PWB/MPP/-copper foil, single-sided board/MPP/PWB/MPP/....../PWB/MPP/-single-sided board, single-sided PWB/MPP/PWB/MPP/....../PWB/-MPP/single-sided PWB, or PWB/MPP/....../PWB/MPP/PWB. In assembling the above-described set of laminate materials, part or all of the laminate materials may be provisionally fixed, for example, by applying a jig to peripheral eyelets, etc., or by means of melt adhesion. Fixing with a jig by applying it to peripheral eyelets or the like is particularly advantageous where positioning of the laminate materials with each other is necessary. In the present invention, the set of laminate materials need not have a construction in which a mirror plate is superposed on both sides thereof, so that the weight and heat capacity of the set of laminate materials are significantly reduced, thereby to attain efficient transfer of the set of laminate materials and an improved thermal efficiency. However, it is possible for the set of laminate materials to include mirror plates. Further, from the standpoints of preventing the wrinkling of the copper foil during the transfer thereof, preventing the fouling of the pressing machine by resin flow, and balancing heat transfer in the pressing machine, it is preferred to use the copper foil in combination with an aluminum, stainless steel or steel plate having a thickness of about 50-200 $\mu$m and a surface roughness of 1 $\mu$m or less, or a thin plate obtained by combining such an aluminum,stainless steel or steel plate with a laminate or by bonding those.

According to the process of this invention, the above-described set of laminate materials is suitably heated to a temperature not higher than the melting point of the PP-impregnating resin, and the set of laminate materials is then maintained at that temperature under a reduced pressure of 100 Torr or less, preferably 60 Torr or less, more preferably 20 Torr or less, for a sufficient period of time to remove most of the air present between and in the laminate materials, thereby to perform prevacuum treatment. If the temperature for the vacuum treatment is higher than the melting point of the PP-impregnating resin, it is difficult to remove the air efficiently in a short period of time. The treatment time is a time required to reduce the ambient pressure to 100 Torr or less, preferably 60 Torr or less, more preferably 20 Torr or less.

While the ambient pressure is substantially maintained at the decreased pressure for the prevacuum treatment, one set of laminate materials is suitably preheated and introduced into a hot platen pressing machine the hot platens of which have been heated. The set of laminate materials in the pressing machine is then heated and pressed with the hot platens, whereby the PP-impregnating resin is melted and allowed to flow and completely fill the spaces in the laminate materials, and is then allowed to undergo a curing reaction. Thus, vacuum pressing is conducted.

The above preheating is conducted by, for example, a method in which the set of laminate materials is introduced into the pressing machine in such a manner that the set is not brought into direct contact with the upper and lower hot platens, and the opening of the pressing machine is closed by raising or lowering the hot platens so that the set of laminate materials is brought into contact with the upper and lower hot platens simultaneously; a method in which heat transfer is controlled so as to be well balanced, by means of a thin plate placed under the lower side of the above-described set of laminate materials; a method in which preheating is performed in a preheating chamber provided between the prevacuum chamber and the pressing machine and equipped with a heating device at the upper and lower parts thereof; or a method in which two or more pressing machines are arranged in series and the first pressing machine is used as a low-temperature pressing machine. It is preferred to suitably use two or more pressing machines.

The pressing and heating conditions for the vacuum pressing can be the conditions for conventional multi-opening presses. Specifically, a pressure of 100 kg/cm$^2$ or less and a temperature of 400°C or less are suitably employed. However, relatively higher pressures are not required in this invention because the pressing is conducted under reduced pressure, and it is possible to obtain sufficiently void-free products at a pressure as low as, for example, about 20 kg/cm$^2$. Although high temperatures are preferred from the standpoint of accelerating the curing to heighten the production efficiency, a complete curing is not necessarily required in this invention and undercuring (semicured state) is sufficient so long as the undercured laminates can be completely cured through postcuring at ordinary pressure or reduced pressure. A desired semicured state can be easily obtained according to the process of this invention, and it is preferred that the process be practiced so as to produce semicured laminates suitable for use in the production of flush circuits, etc. In the case where the matrix resin of the PP is an epoxy resin, a semicured state is attained when the bonding strength of the copper foil has reached 0.3 kg/cm or more (glass transition temperature of the epoxy resin being about 120°C). Specifically, the time for the heat pressing is preferably selected from the range of from 30 seconds to 10 minutes. It should be noted that when a heat gelation reaction is proceeded rapidly at a high temperature, chemical and water resistance to be attained by normal curing cannot be obtained in some cases even through postcuring. If such a PP is used, it is preferred that the above-described preheating be positively employed or two or more vacuum pressing machines be arranged in series and heat pressing at a lower temperature be performed in combination with heat pressing at a higher temperature.

According to the vacuum pressing in the process of this invention, since one set of laminate materials is pressed basically by one pressing operation, it is generally not necessary to use cushioning mediums for use in usual multi-opening presses and use a mirror plate or the like for each set of laminate materials. The pressing according to the present invention can be conducted by the use of hot platens having an overlay of a mirror plate or a hard metal plate having a surface roughness of 1 μm or less, or by the use of a mirror-surface metal foil placed at both sides of the set of laminate materials. Alternatively, the pressing may be conducted while a continuous mirror-surface metal foil or a mirror-surface metal foil in endless belt form is fed continuously onto the hot platens. Where such mirror foils are used repeatedly, it is preferred to apply a release agent beforehand on the surface of the foils.

After the PP-impregnating resin has been semicured or cured by the vacuum pressing according to the process of this invention, the hot platens are opened. Subsequently, the resulting laminate is normally transferred to a withdrawal chamber which can be kept vacuum, and is then taken out of the withdrawal chamber. This withdrawal chamber can also function as a cooling chamber.

Examples of a means for transferring the set of laminate materials or the laminate include chucks, a transfer belt made of metal foil, etc., and rollers. In the case of a pressing machine having a construction in which the hot platens are overlaid with a mirror plate or in the case where a mirror foil is placed at both sides of the set of laminate materials, chuck transfer is preferably employed. If the transferring means is intended to perform the function of a mirror plate, a hard metal foil having a surface roughness of 1 μm or less is preferred as the transferring means. As the mirror foil for use in this invention, a foil of a metal such as stainless steel, steel, etc., which has a surface roughness of 1 μm or less is preferred from the standpoint of appearance of the laminate produced by the pressing. Other examples of mirror foils which can be used in this invention include an aluminum foil, a copper foil, foils of other metals, a copper foil for use as a laminate material, and heat-resistant resin films. In the case where the mirror foil is used as a throwaway foil or where a support plate is used on which the set of laminate materials is placed, a thin foil made of iron or steel and having a surface roughness of 1 μm or less, such as those for use in automotive outer plates, and an aluminum foil are preferably employed.

The vacuumizing system employed in the process of this invention is designed so as to produce a desired degree of vacuum in a properly short period of time, with the volumes of the prevacuum chamber, pressing machine, and withdrawal chamber, and the spaces required for housing the transferring means and other devices being considered. Preferably employed as the vacuumizing system is a system comprising a vacuum pump, pipings, and valves, which vacuum pump basically has a somewhat large evacuation capacity so as to attain a desired degree of vacuum in a period of generally 2 minutes or less, preferably 1 minute or less, more preferably 30 seconds or less. It is preferred to provide the vacuumizing system with a vacuum shutter between units, i.e., between the prevacuum chamber and the pressing machine and between the pressing machine and the withdrawal chamber. Furthermore, it is also preferred that each unit is designed so as to have an actual volume as small as possible.

The atmosphere around the pressing apparatus is preferably kept clean since inclusion or evolution of dust in the process of this invention often results in defective products. In particular, filtered air is used as the air to be introduced into the pressing apparatus at the time when a set of laminate materials is sent in or a laminate product is taken out.

The apparatus for use in the above-described novel process of this invention for the vacuum, continuous batch production of laminates will be explained below by reference to the accompanying drawings which show examples of the apparatus.

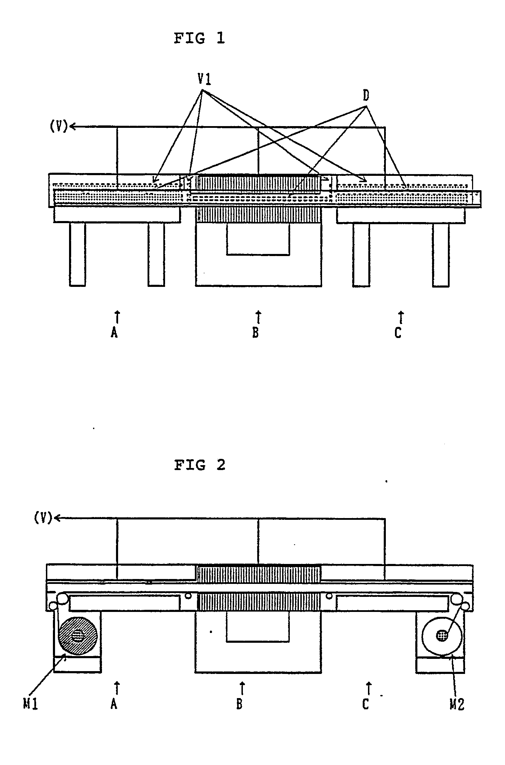

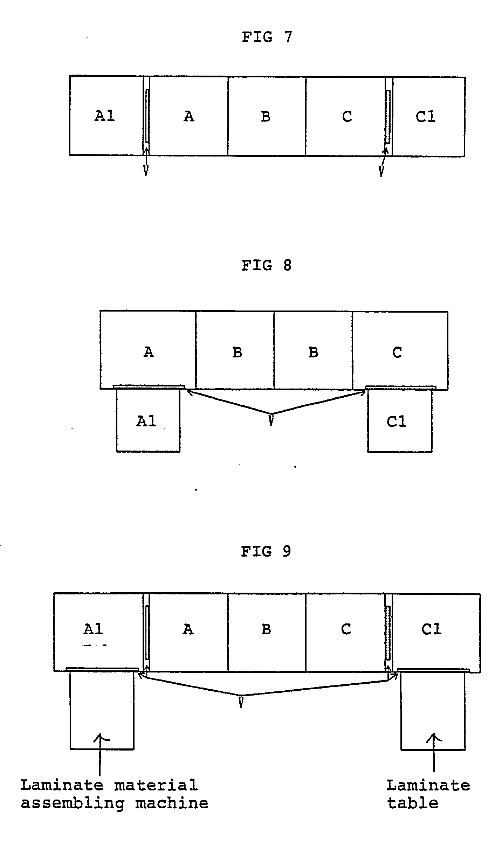

Fig. 1 illustrates the basic construction of an example of the apparatus of this invention. This apparatus comprises a prevacuum chamber (A), a pressing machine (B), and a withdrawal chamber (C), these being connected in series in this order. The prevacuum chamber A is provided with a vacuum shutter (V1) at an inlet for a set of laminate materials, while the withdrawal chamber C is provided with a vacuum shutter (V1) at an withdrawal opening for a laminate. The pressing machine is provided therein with a means for transferring a set of laminate materials, and although not essential, a vacuum shutter is provided between units A and B and between units B and C. In the apparatus of Fig. 1, a transferring means (D), such as chucks, for transferring a set of laminate materials or a laminate is provided in the space by the horizontal side of the hot platens and at the ceilings of the prevacuum chamber A and withdrawal chamber C. A laminate material set table and a laminate table, both not shown in Fig. 1, are provided in the prevacuum chamber A and the withdrawal chamber C, respectively, the two tables being suitably connected directly with the vacuum shutter of the prevacuum chamber A and that of the withdrawal chamber C, respectively, as shown in Fig. 7.

An example of the process of this invention is explained below by reference to Fig. 1. A predetermined set of laminate materials in which a thin stainless steel plate or steel plate is suitably used for preventing the wrinkling of the copper foil during the transfer of the set is placed on the laminate material set table at a predetermined position, and the set of laminate materials is then sent in the prevacuum chamber A by a transferring means. The vacuum shutter in the prevacuum chamber A is then closed, and this chamber is rapidly evacuated with a vacuum pump. After the pressure in the chamber has reached a predetermined value, which is not higher than 100 Torr, the vacuum shutter between this chamber and the pressing machine B is opened, and the set of laminate materials is transferred to a predetermined position between the hot platens of the pressing machine by the transferring means D provided at both horizontal sides of the pressing machine. The hot platens are then closed to press the set of laminate materials for a predetermined period of time. After the pressing, the vacuum shutter between the pressing machine and the withdrawal chamber C is opened, the laminate formed is transferred to the withdrawal chamber by means of the transferring means D provided in the withdrawal chamber, and the vacuum shutter between the pressing machine and the withdrawal chamber is closed. Subsequently, the vacuum shutter at the withdrawal opening of the withdrawal chamber C is opened, and the laminate is taken out of the apparatus. On the other hand, the vacuum shutter between the prevacuum chamber A and the pressing machine B is closed, another set of laminate materials is introduced into the prevacuum chamber A in the same manner as above, and evacuation is then commenced.

By repeating the above cycle, laminates are manufactured batch-wise and continuously.

In the case where a vacuum shutter is not provided between the prevacuum chamber A and the pressing machine B and between the pressing machine B and the withdrawal chamber C in the apparatus described above, laminates are produced as follows. At the time when the pressing of a set of laminate materials in the pressing machine has reached a predetermined stage, the shutter in the prevacuum chamber A and that in the withdrawal chamber C are opened, and a set of laminate materials is transferred to the prevacuum chamber A and the laminate formed is withdrawn from the pressing machine. These vacuum shutters are then closed and evacuation is initiated. At the time when the inside pressure has reached a predetermined vacuum, the hot platens are opened, and the laminate is transferred to the withdrawal chamber C and the set of laminate materials is transferred onto the lower hot platen, under reduced pressure. The set of laminate materials is then pressed for a predetermined period of time. The above-described cycle, which comprises transfer of a set of laminate materials and withdrawal of a laminate, is repeated to produce laminates.

Fig. 2 illustrates the basic construction of an example of the vacuum, continuous batch pressing apparatus of this invention which employs a continuous metal foil as a transferring means.

In the apparatus of Fig. 2, a continuous mirror foil feed roll (M1) is provided under the prevacuum chamber A at the end thereof remote from the pressing machine B, and a continuous mirror foil wind-up roll (M2) is provided under the withdrawal chamber C at the end thereof remote from the pressing machine B. The transfer of a set of laminate materials and a laminate under reduced pressure is conducted by running the continuous mirror foil by a predetermined distance. The prevacuum chamber A is provided on its ceiling with a transferring means which introduces a set of laminate materials from a laminate material set table (A1) into the prevacuum chamber A.

An example of the process of this invention employing the apparatus of Fig. 2 is explained below by reference to Fig. 7. A predetermined set of laminate materials in which an auxiliary plate is suitably used for preventing the wrinkling of the copper foil is placed on the laminate material set table A1 at a predetermined position. The vacuum shutter V1 is opened, and the set of laminate materials is sent in the prevacuum chamber A by the transferring means provided in the prevacuum chamber A. The vacuum shutter V1 is closed, and the prevacuum chamber A is rapidly evacuated with a vacuum pump so that the pressure in the chamber is reduced to a predetermined value not higher than 100 Torr. Under such reduced pressure, the hot platens of the pressing machine B is opened and the continuous mirror foil of metal is wound up by the continuous mirror foil wind-up roll M2 by a predetermined length, so that the set of laninate materials and a laminate formed by pressing are transferred to the hot platens of the pressing machine and the withdrawal chamber, respectively. The set of laminate materials in the pressing machine is pressed, while the laminate in the withdrawal chamber is cooled if necessary. At the time when the pressing of the set of laminate materials in the pressing machine has reached a predetermined stage, clean air is introduced into the prevacuum chamber A and the withdrawal chamber C, the vacuum shutter in the prevacuum chamber A and that in the withdrawal chamber C are opened, and a set of laminate materials is sent in the prevacuum chamber A and also the laminate formed by pressing is withdrawn from the apparatus. By repeating the above cycle using the apparatus shown in Fig. 2, laminates are produced continuously.

In the case where the above-described apparatus is further provided with a vacuum shutter at the front and back of the pressing machine B or where the above-described apparatus is further provided with an auxiliary vacuum laminate material set table disposed at the front of the prevacuum chamber and with an auxiliary vacuum laminate table disposed at the back of the withdrawal chamber, there is an advantage that the introduction of a set of laminate materials and the withdrawal of the laminate at a predetermined stage of the pressing are not essential.

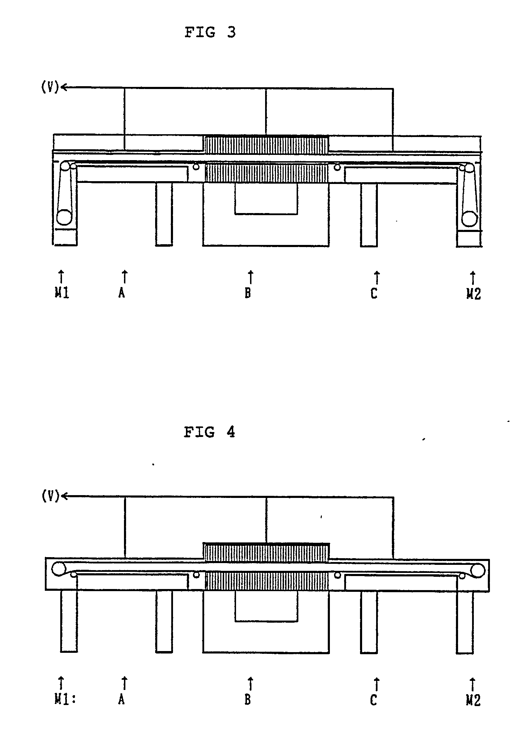

Figs. 3 and 4 illustrate examples of the apparatus of this invention which employs an endless metal foil belt as a transferring means D for transferring a set of laminate materials. In the apparatus of Fig. 3, the endless metal foil belt is disposed on the floor surface. In the apparatus of Fig. 4, the endless metal foil belt is arranged to run along both bottom and top of the inner space.

The process for producing laminates using the apparatus of either Fig. 3 or Fig. 4 is substantially the same as the process explained hereinabove by reference to Fig. 2 except that an endless metal foil belt is used. In the case of the apparatuses of Figs. 3 and 4, since the endless metal foil is repeatedly used for the pressing of assemblies of laminate materials, the surface of the endless metal foil belt should be free from dirt and always clean. For this purpose, it is preferred to suitably dispose a cleaning device around housing and driving units for endless metal foil belt (M1, M2).

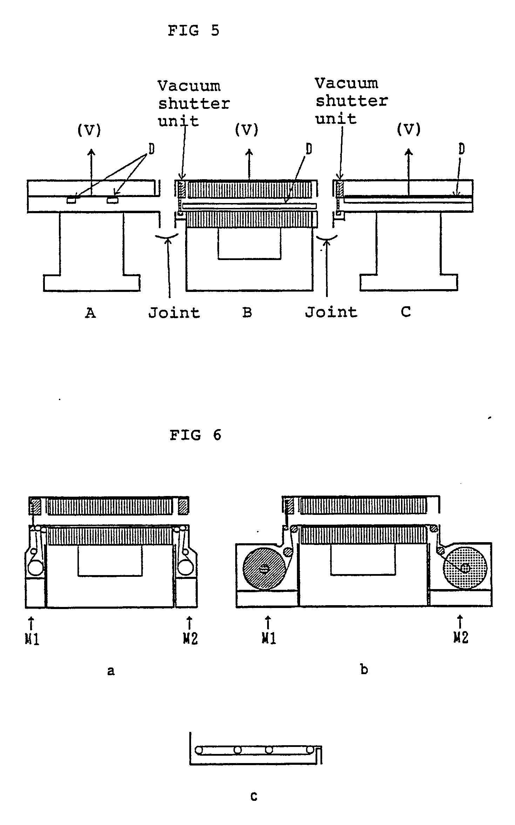

Figs. 5 and 6 illustrate examples of the vacuum, continuous batch pressing apparatus of this invention, composed of separable units. In Fig. 6, a and b illustrate a pressing machine unit equipped with housing and driving units for an endless metal belt and for a continuous metal foil, respectively, while c illustrates an example of a transferring unit in the case where the prevacuum chamber A or the withdrawal chamber C is transferred by a belt roll conveyor.

Since the apparatuses of Figs. 5 and 6 are composed of units, a vacuum laminate material set table A1 can be used as the prevacuum chamber A unit and a vacuum laminate table C1 can be used as the withdrawal chamber unit C, in the case as shown in Fig. 7. Further, it is also possible to combine two or more pressing machine units B to use them as a low-temperature pressing machine and a high-temperature pressing machine, as shown in Fig. 8. Furthermore, if the apparatus is made up of units of the same standards, maintenance of the apparatus can be performed unit by unit, leading to an improved working efficiency of the apparatus.

In Fig. 5, a prevacuum chamber unit (A), a pressing machine unit (B), and a withdrawal chamber unit (C) are connected in series in this order to give a vacuum, continuous batch pressing apparatus of this invention. The prevacuum chamber A is provided at a side thereof with a vacuum shutter unit(not shown) through which a set of laminate materials is sent in, the vacuum shutter being the same as that disposed at the joint between the pressing machine unit B and the withdrawal chamber unit C, while the withdrawal chamber C is likewise provided at a side thereof with a vacuum shutter for withdrawing a laminate. Each of the units A, B, and C is provided with a chuck-type transferring means (D), and the apparatus is further provided with joints which airtightly connect the units. In Fig. 6, a and b illustrate the pressing machine unit B of Fig. 1 in which its transferring means is an endless metal foil belt and a continuous metal foil, respectively, and the pressing machine is provided at both sides thereof with housing units (M1, M2) for housing and driving the belt or foil. Fig. 6, c illustrates an example of a belt conveyor for use in the prevacuum chamber unit A and the withdrawal chamber unit C, the belt conveyor being simple as compared with the transferring means in a and b above.

Figs. 7, 8, and 9 each is a schematic plan view illustrating the arrangement of units of an apparatus of this invention in which a laminate material set feed unit, a laminate withdrawal unit, etc., have been added and all the units have been united. Fig. 7 illustrates an example of unit arrangement for an apparatus constructed by uniting a laminate material set feed table (A1) and a laminate withdrawal table (C1) in the apparatus of Figs. 1 to 5. Fig. 8 illustrates an example of unit arrangement for an apparatus constructed by replacing the pressing machine of the apparatus of Fig. 7 with a pressing machine for low temperatures and a pressing machine for high temperatures. Fig. 9 illustrates an apparatus constructed by further providing the apparatus of Fig. 7 or 8 with a laminate material-assembling machine and a laminate table so as to make the laminate material set table (A1) and the laminate table (C1) vacuumizeable.

The apparatus of this invention has been explained above by reference to the accompanying drawings, but the apparatus is not limited to these and it may have any construction so long as it comprises a prevacuum chamber (A), a pressing machine (B), and a withdrawal chamber (C). For example, the following modifications are possible: the prevacuum chamber is used as a table for assembling laminate materials into a set under reduced pressure; the prevacuum chamber is so modified that a plurality of sets of laminate materials can be introduced thereinto, and prepregs and printed wiring boards can be predried therein under reduced pressure; and a vacuum predryer is combined with the apparatus.

As is apparent from the above detailed description of this invention, laminates substantially free from defects such as voids can be produced according to the vacuum, continuous batch pressing process for producing laminates according to this invention and the apparatus for such process, since vacuum pretreatment is performed first, followed by pressing under reduced pressure. Furthermore, because no mirror plate is used for sets of laminate materials and one laminate is produced by one pressing operation, handling of the materials is easy and laminates excellent in dimensional accuracy and other properties can be manufactured. If two or more pressing machines are arranged in series in the apparatus of this invention, sets of laminate materials containing any kind of prepreg can be pressed into semicured or cured laminates having good properties.

In addition, the pressing process of this invention can be practiced fully automatically and the process can be incorporated, without difficulty, into existing processes for producing printed wiring boards, multilayer boards, etc. Therefore, the process of the present invention is of considerable industrial significance.

While the invention has been described in detail and with reference to specific embodiments thereof, it will be apparent to one skilled in the art that various changes and modifications can be made therein without departing from the sprit and scope thereof.

## Claims

1. A vacuum, continuous batch process for producing laminates, which comprises repeating a cycle comprising placing a pre-assembled set of laminate materials containing a prepreg in a vacuum of 100 Torr or less at a temperature not higher than the melting point of the prepreg-impregnating resin, transferring the set of laminate materials under the reduced pressure to the space between hot platens of a pressing machine, pressing the set of laminate materials until said prepreg-impregnating resin is cured to a desired degree, opening the hot platens, and then withdrawing a laminate formed by the pressing.

2. A process as claimed in claim 1, wherein said set of laminate materials is a copper-clad laminate or a multilayer board.

3. A process as claimed in claim 1, wherein the pressing is conducted in such a manner that the prepreg resin in the laminate obtained is in a semicured state.

4. A process as claimed in claim 1, wherein the transfer of said set of laminate materials under reduced pressure is conducted by means of a continuous metal foil.

5. A process as claimed in claim 1, wherein the transfer of said set of laminate materials under reduced pressure is conducted by means of an endless metal foil belt.

6. A pressing apparatus for vacuum, continuous batch pressing, which comprises a prevacuum chamber (A) for keeping a set of laminate materials under reduced pressure, a pressing machine (B), a withdrawal chamber (C) which can be kept vacuum, a transferring means (D) for transferring a set of laminate materials and a laminate, and a vacuumizing system for evacuating said A, B, and C, said A, B, and C being connected in series in this order.

7. An apparatus as claimed in claim 6, wherein said pressing machine B is composed of at least two pressing machines arranged in series.

8. An apparatus as claimed in claim 6, wherein said prevacuum chamber A is provided with a vacuumizeable laminate material set table (A1) and said withdrawal chamber C is provided with a vacuumizeable laminate table (C1).

9. An apparatus as claimed in claim 6, wherein said transferring means D is a continuous metal foil.

10. An apparatus as claimed in claim 9, wherein said prevacuum chamber A is provided with a continuous metal foil feed roll unit (M1) in which said continuous metal foil has been wound around the roll, and said withdrawal chamber C is provided with a wind-up roll unit (M2) for said continuous metal foil, part of said continuous metal foil being stretched at least along the floor of the inside of the apparatus from the prevacuum chamber A to the withdrawal chamber C, the stretched part of said continuous metal foil being able to be run freely.

11. An apparatus as claimed in claim 9, wherein said continuous metal foil is a foil made of a metal selected from aluminum, stainless steel, and steel, and having a surface roughness of 1 $\mu$m or less, and functions as a mirror plate.

12. An apparatus as claimed in claim 9, wherein a roll of said continuous metal foil is cleaned in a separate process after one roll operation and reused.

13. An apparatus as claimed in claim 6, wherein said transferring means D is an endless metal foil belt.

14. An apparatus as claimed in claim 13, wherein said prevacuum chamber A and said withdrawal chamber C each is provided with a housing and driving unit for an endless mirror foil belt (M1, M2), and said endless metal foil belt is stretched at least along the floor of the inside of the apparatus from the prevacuum chamber A to the withdrawal chamber C, said endless metal foil belt being able to be run freely.

15. An apparatus as claimed in claim 13, wherein the whole of said endless metal foil belt is housed in the vacuumizeable inside of the apparatus.

16. An apparatus as claimed in claim 13, wherein said endless metal foil belt is a foil made of a metal selected from stainless steel and steel, and having a surface roughness of 1 $\mu$m or less, and one or both ends are suitably provided with a means for cleaning the belt and applying a release agent to the belt.

17. A pressing apparatus for vacuum, continuous batch pressing, which comprises a prevacuum chamber (A) for keeping at least a set of laminate materials under reduced pressure, a pressing machine (B), a withdrawal chamber (C) which can be kept vacuum, a transferring means (D) for transferring a set of laminate materials and a laminate, and a vacuumizing system for evacuating said A, B, and C, said A, B, and C being connected in series in this order, each of said A, B, and C being a unit which can be airtightly connected with other unit or units and separated therefrom, said transferring means being disposed in each unit independently.

18. An apparatus as claimed in claim 17, wherein said transferring means D is a chuck-type transferring means.

19. An apparatus as claimed in claim 17, wherein the transferring means in said prevacuum chamber A or said withdrawal chamber C is a roller conveyor or a belt roller conveyor.

20. An apparatus as claimed in claim 17, wherein the transferring means in said pressing machine B is a continuous metal foil or an endless metal foil belt, and said pressing machine is able to be provided with a removable housing and driving unit for said continuous metal foil or endless metal foil belt.

FIG 1

FIG 2

FIG 3

(V)

↑
M1

↑
A

↑
B

↑
C

↑
M2

FIG 4

(V)

↑
M1:

↑
A

↑
B

↑
C

↑
M2

FIG 5

Vacuum shutter unit

Vacuum shutter unit

(V)    D

(V)    D

(V)    D

A    Joint    B    Joint    C

FIG 6

M1    M2

a

M1    M2

b

c

FIG 7

| A1 | | A | B | C | | C1 |

FIG 8

| A | B | B | C |

A1        C1

FIG 9

| A1 | | A | B | C | | C1 |

Laminate material
assembling machine

Laminate
table

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 215 358 (HITACHI CEHMICAL CO., LTD) <br> * Page 9, line 17 - page 15, line 10; page 16, lines 10-18; page 18, lines 15-23; figure 1 * | 6,7 | B 32 B 31/04 <br> B 32 B 31/20 <br> B 29 C 43/56 |
| Y | | 1-3,5,9 ,11,13- 17,19, 20 | |
| Y | PATENT ABSTRACTS OF JAPAN, vol. 12, no. 98 (M-680)[2945], 31st March 1988; & JP-A-62 233 212 (MATSUSHITA ELECTRIC WORKS LTD) <br> * Abstract * | 1,2 | |
| Y | FR-A-2 276 759 (IBM CORP.) <br> * Page 3, line 10 - page 4, line 8; claims 1-4 * | 1,3 | |
| Y | DE-A-3 445 462 (MBB GmbH) <br> * Page 11, line 25 - page 12, line 14 * | 1,3 | TECHNICAL FIELDS SEARCHED (Int. Cl.5) |
| Y | US-A-3 901 639 (D.R. MANDELSON et al.) <br> * Column 3, lines 7-10; claim 1 * | 1,5,9, 11,13- 17,19, 20 | B 32 B <br> B 29 C |
| Y | EP-A-0 055 862 (DELOREAN RESEARCH LTD) <br> * Abstract * | 17 | |
| A | US-A-4 234 373 (J.A. REAVILL et al.) <br> * Figures 4-8 * <br> ---         -/- | 1,2,6-8 ,17 | |

The present search report has been drawn up for all claims

| Place of search | Date of completion of the search | Examiner |
|---|---|---|
| THE HAGUE | 13-07-1990 | PHILPOTT G.R. |

European Patent Office

**EUROPEAN SEARCH REPORT**

Application Number

EP 90 10 5338

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | US-A-3 960 635 (D. LA ROY et al.) * Column 1, lines 57-68; column 3, line 3 - column 4, line 10; figure 2 * | 1,2,6-8,17 | |
| A | DE-A-3 725 007 (MATSUSHITA ELECTRICAL WORKS LTD) * Column 3, lines 46-49; column 4, lines 3-41 * | 1,2,6-8,17,18 | |

TECHNICAL FIELDS SEARCHED (Int. Cl.5)

The present search report has been drawn up for all claims

| Place of search | Date of completion of the search | Examiner |
|---|---|---|
| THE HAGUE | 13-07-1990 | PHILPOTT G.R. |